(19) **Europäisches Patentamt**
**European Patent Office**
**Office européen des brevets**

(11) **EP 2 463 671 A1**

(12) **EUROPEAN PATENT APPLICATION**
published in accordance with Art. 153(4) EPC

(43) Date of publication:
**13.06.2012 Bulletin 2012/24**

(51) Int Cl.:
**G01R 31/08** (2006.01)

(21) Application number: **10806213.4**

(22) Date of filing: **30.07.2010**

(86) International application number:
**PCT/JP2010/004852**

(87) International publication number:
**WO 2011/016213 (10.02.2011 Gazette 2011/06)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **05.08.2009 JP 2009182865**

(71) Applicant: **Kabushiki Kaisha Toshiba**
**Minato-ku**
**Tokyo 105-8001 (JP)**

(72) Inventors:
• **TAKANI, Hideyuki**
  **Tokyo 105-8001 (JP)**
• **SHONO, Takaya**
  **Tokyo 105-8001 (JP)**

(74) Representative: **Henkel, Breuer & Partner**
**Patentanwälte**
**Maximiliansplatz 21**
**80333 München (DE)**

(54) **FAULT LOCATION METHOD AND SYSTEM**

(57) Disclosed is a fault location method in which a fault is located using the voltage, current and transmission line constants of each terminal of a transmission line in which a fault is to be located. In this method, a simplified expression is obtained from a basic expression of a distributed constant circuit equation using a hyperbolic function by means of a second-order approximation using an approximation of a hyperbolic function, or alternatively a simplified expression is obtained by the division of both sides by means of a hyperbolic unction. The distance to the location of the fault from a prescribed end of the transmission line is calculated using the simplified expression.

*FIG. 1*

**Description**

FIELD

Embodiments of the present invention relates to a method and a system of locating a fault point of the power transmission line.

BACKGROUND

In general, a fault point location uses a condition that fault point voltages when viewed from both ends of a location subject section are equal and the distance from an end of the location subject section to a fault point is identified by determining an impedance from a current flowing through a transmission line and a voltage. The accuracy of fault point location of a power transmission line greatly affects a restoration time. Thus, an improvement in location accuracy is always demanded in fault point location technology of a power transmission line.

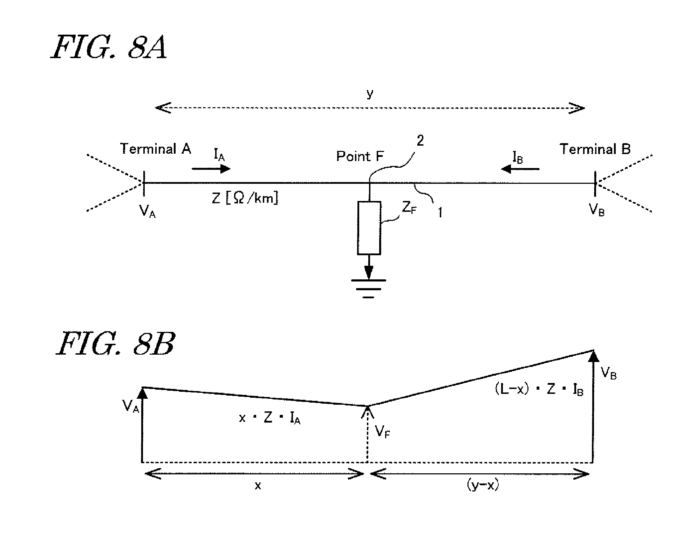

A conventional fault point location method will be concretely described with reference to FIGS. 8A and 8B. FIG. 8A is a circuit diagram of a transmission line to be located and FIG. 8B is a diagram of voltage distribution in the direction of a transmission line length. As shown in FIG. 8A, a line length y having a transmission line constant Z (vector quantity) per unit length is set to a transmission line 1 having an terminal A and a terminal B. It is assumed that the voltage at the terminal A during a fault is $V_A$, the current is $I_A$, the voltage at the terminal B during a fault is $V_B$, and the current is $I_B$.

As shown in FIG. 8B, if the location distance from the terminal A to a fault point 2 (point F) is x, voltages $V_F$ (vector quantity) when the fault point 2 (point F) is viewed from the terminal A and the terminal B are equal. Thus, Formula (1) below holds:

[Formula 1]

$$\dot{V}_A - x \cdot \dot{Z} \cdot \dot{I}_A = \dot{V}_F = \dot{V}_B - (y - x) \cdot \dot{Z} \cdot \dot{I}_B \quad \cdots (1)$$

In the above Formula (1), the left side represents the voltage when the fault point 2 (point F) is viewed from the terminal A and the right side represents the voltage when the fault point 2 (point F) is viewed from the terminal B. Therefore, the location distance x can be calculated by Formula (2) below:

[Formula 2]

$$x = \frac{\dot{V}_A - \dot{V}_B + y \cdot \dot{Z} \cdot \dot{I}_B}{\dot{Z} \cdot (\dot{I}_A + \dot{I}_B)} \quad \cdots (2)$$

The above Formula (2) is a formula that holds for vector quantities of the voltage/current at the terminal A and the terminal B at both ends of the line length y. Thus, to allow Formula (2) to hold, it is necessary to synchronize the current/voltage received at each of the terminal A and the terminal B. Methods of synchronizing the current/voltage at the terminal A and the terminal B by using a sampling synchronizing signal or a GPS signal have been proposed.

When calculating the location distance x, it cannot be denied that a location error occurs depending on circumstances of a fault. Thus, it is useful to assume the range of a location error when locating a fault point. Therefore, technologies to determine an assumed error are known.

However, the magnitude of an assumed error is not simply proportional to the location distance and depending on circumstances of a fault, both may not be proportional at all. To tackle such a problem, a method of deriving an assumed error value having probabilistically the smallest error is proposed.

Patent Document 1: Japanese Patent Publication No. 2818248
Patent Document 2: Japanese Patent Publication No. 3356484
Non-Patent Document 1: "Fault Point Spotting Device of Transmission Line" by Hoki and Kitani, 1957, Ohmsha, Ltd., p. 45

However, the following problem of the conventional fault point location technology has been pointed out. That is, a transmission line of a long-distance transmission line whose length reaches a few tens of kilometers or a cable transmission line has a large electrostatic capacitance and accordingly a charging current is large. In such transmission lines, a location error is likely to be large because electrical quantity data gathered at both ends of a line to be located during a fault is affected by a charging current.

If a location error grows, the range of an assumed error also increases. That is, even if the assumed error is not proportional to the location distance, the assumed error is proportional to the location error. Thus, in a power transmission line likely to be affected by the electrostatic capacitance or charging current, reducing a location error itself without relying on the calculation of an assumed error is particularly demanded. Moreover, there are some cases in recent years when the realization of a fault point location system by using a simple computation unit such as a so-called embedded processor is desired. Therefore, there is an increasing tendency to demand the lowering of the degree of difficulty of fault point location calculation processing.

BRIEF DESCRIPTION OF THE DRAWING

FIG. 1 is a block diagram of a first embodiment.
FIG. 2 is a flow chart of an input processing apparatus according to the first embodiment.
FIG. 3 is a flow chart of a location processing apparatus according to the first embodiment.
FIG. 4 is a diagram illustrating an operation effect of the first embodiment.
FIG. 5 is a flow chart of the location processing apparatus according to a second embodiment.
FIG. 6 is a flow chart of the input processing apparatus according to a modification of the second embodiment.
FIG. 7 is a flow chart of the location processing apparatus according to the modification of the second embodiment.
FIGS. 8A and 8B show a conventional fault point location method, FIG. 8A is a circuit diagram of a transmission line, and FIG. 8B is a diagram of voltage distribution in the direction of a transmission line length.

I7ETAILED DESCRIPTION

According to an embodiment, a fault location method of locating a fault point by using a voltage and a current of each terminal of a transmission line to be located and a transmission line constant is shown. According to the method, a formula simplified by a secondary approximation using an approximation of a hyperbolic function from a basic equation of a distributed constant circuit equation using the hyperbolic function or the formula simplified by a division of both sides by the hyperbolic function is determined. A location distance from a predetermined end of the transmission line to the fault point is calculated by using the simplified formula.

(1) First embodiment

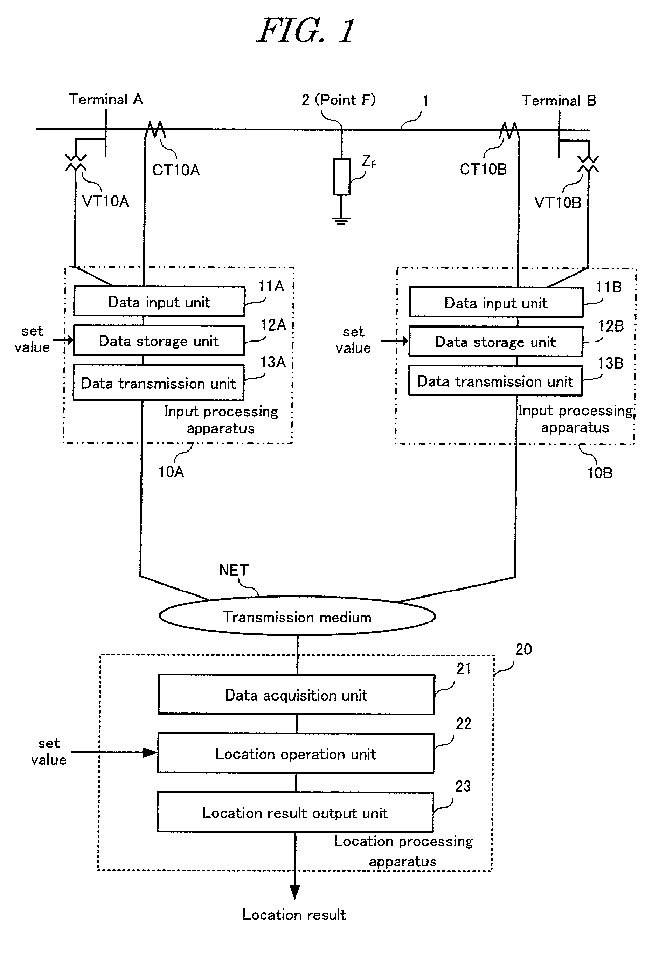

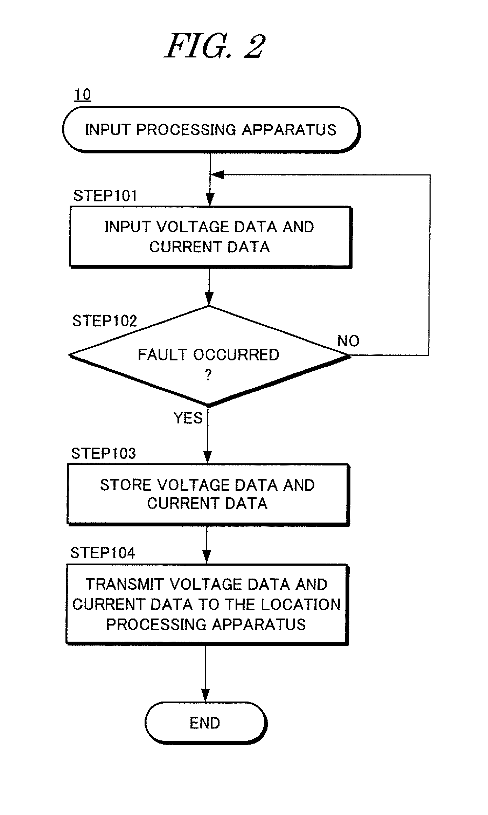

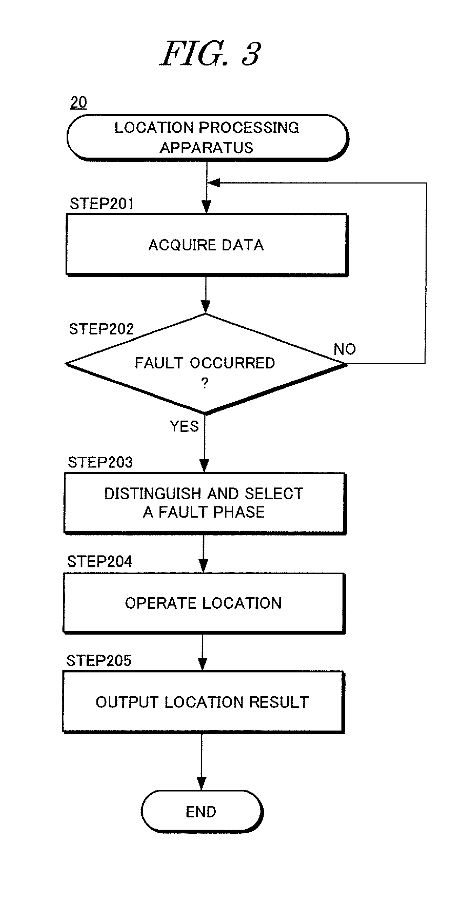

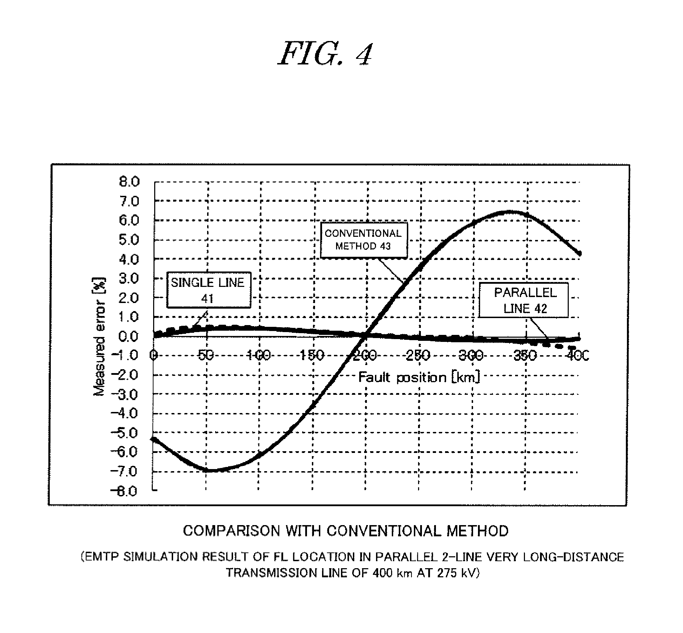

The first embodiment will be described below with reference to FIGS. 1 to 4. FIG. 1 is a block diagram of a fault point location system according to first embodiment, FIGS. 2 and 3 are flow charts showing a processing function of an input processing apparatus and a location processing apparatus constituting the fault point location system respectively, and FIG. 4 is a diagram illustrating an operation effect of the first embodiment. The schematic diagram when a transmission line fault occurs and the diagram of voltage distribution at the terminal A, the terminal B, and the fault point 2 in the first embodiment are the same as those of the conventional example shown in FIG. 8.

(Configuration)

Before describing features of a fault point location method according to the first embodiment, an overview of a fault point location system will be provided with reference to FIG. 1. In FIG. 1, reference numeral 1 denotes a two-terminal transmission line to be located having the terminal A and the terminal B at both ends. A current transformer CT10A and a voltage transformer VT10A are installed on the terminal A side and a current transformer CT10B and a voltage transformer VT10B are installed on the terminal B side.

A fault point location system according to the first embodiment includes input processing apparatuses 10A, 10B installed for the terminals A and B respectively and a location processing apparatus 20 connected to the input processing apparatuses 10A, 10B via a transmission medium NET. The input processing apparatuses 10A, 10B and the location processing apparatus 20 are configured as a digital computer, for example, a microprocessor.

The input processing apparatuses 10A, 10B are provided with data input units 11A, 11B, data storage units 12A, 12B, and data transmission units 13A, 13B respectively. Among these units, the data input unit 11A receives input of the current and voltage at the terminal A from the current transformer CT10A and the voltage transformer VT10A respectively and converts the electrical quantity data into digital data. The data input unit 11B receives input of the current and voltage at the terminal B from the current transformer CT10B and the voltage transformer VT10B respectively and converts the electrical quantity data into digital data.

The data storage units 12A, 12B are units that store electrical quantity data when a fault occurs in a memory based on setting values such as a data storage time. The data transmission units 13A, 13B are units that transmit electrical quantity data stored in the memory to the transmission medium NET.

The location processing apparatus 20 is provided with a data acquisition unit 21, a location operation unit 22, and a location result output unit 23. Among these units, the data acquisition unit 21 is a unit that receives data transmitted from the data transmission units 13A, 13B of the input processing apparatuses 10A, 10B. The location result output unit 23 is a unit that outputs a location operation result calculated by the location operation unit 22.

The location operation unit 22 is a characteristic unit of the present embodiment and has setting values such as the transmission line constant Z (vector quantity) of the transmission line 1 to perform a location operation of a fault point as shown below based on the setting values and the current and voltage data acquired by the data acquisition unit 21.

That is, the location operation unit 22 determines a location distance from a predetermined end of the transmission line 1 to a fault point by using an approximation of a distributed constant circuit equation. Then, the location operation unit 22 uses the determined location distance as an initial location result to calculate a final location result by carrying out a recursive convergence calculation for the initial location result. Concrete expressions of the distributed constant circuit equation and the approximation will be described in (Location method) described next.

(Location method)

Subsequently, the fault point location method according to the first embodiment will be described. First, at the terminal A of the transmission line 1 to be located, the voltage transformer VT10A and the current transformer CT10A gather the voltage $V_A$ and the current $I_A$ during a fault respectively. At the terminal B of the transmission line 1, the voltage transformer VT10B and the current transformer CT10B gather the voltage $V_B$ and the current $I_B$ during a fault respectively.

The data input unit 11A of the input processing apparatus 10A inputs the voltage $V_A$ and the current $I_A$ gathered by the voltage transformer VT10A and the current transformer CT10A. The data input unit 11B of the input processing apparatus 10B inputs the voltage $V_B$ and the current $I_B$ gathered by the voltage transformer VT10B and the current transformer CT10B.

The processing of the input processing apparatuses 10A, 10B will be described below with reference to the flow chart in FIG. 2. When it is not necessary to distinguish the input processing apparatus on the terminal A side and the input processing apparatus on the terminal B side in the description of the input processing apparatus, subscripts A, B are omitted.

As shown in FIG. 2, in step 101, the data input unit 11 of the input processing apparatus 10 inputs voltage and current data from each terminal. The data input units 11A, 11B receive input of the voltage $V_A$ and the current $I_A$, and the voltage $V_B$ and the current $I_B$ respectively for conversion into digital data.

Next, in step 102, whether any fault has occurred is checked based on setting values of fault detection sensitivity and the like. If it is determined that no fault has occurred (No in step 102), the processing returns to step 101. On the other hand, if it is determined that a fault has occurred (Yes in step 102), the processing proceeds to step 103 to store voltage and current data. Steps 102 and 103 are handled by the data storage unit 12 in FIG. 1.

That is, the data storage unit 12 stores the digital voltage and current data $V_A$, $I_A$, $V_B$, $I_B$ during a fault in the memory based on setting values such as the data storage time. In next step 104, the data transmission unit 13 transmits the digital voltage and current data $V_A$, $I_A$, $V_B$, $I_B$ during a fault to the location processing apparatus 20.

Subsequently, the processing function of the location processing apparatus 20 will be described by using the flow chart in FIG. 3. That is, in step 201, the data acquisition unit 21 of the location processing apparatus 20 acquires data transmitted from the input processing apparatuses 10A, 10B.

Then, if, in step 202, it is determined that a fault has occurred (Yes in step 202), in step 203, a fault phase is selected. Further, in step 204, a location operation is performed by using fault phase voltage and respective phase current data, the line length y of the transmission line 1, and setting values such as the transmission line constant Z per unit length. If, in step 202, it is determined that no fault has occurred (No in step 202), the processing returns to step 201.

Steps 202, 203, and 204 are processing steps corresponding to the location operation unit 22 in FIG. 1. A relational expression for a distributed constant circuit of the voltage/current $V_A$, $I_A$ acquired on the terminal A side is given as Formula (3) below using a hyperbolic function. A relational expression for a distributed constant circuit of the voltage/current $V_B$, $I_B$ acquired on the terminal B side is given as Formula (4) below using a hyperbolic function:

[Formula 3]

$$\begin{bmatrix} V_F \\ I_{FA} \end{bmatrix} = \begin{bmatrix} \cosh(\lambda x) & -Z \cdot \sinh(\lambda x) \\ \dfrac{1}{Z}\sinh(\lambda x) & -\cosh(\lambda x) \end{bmatrix}\begin{bmatrix} V_A \\ I_A \end{bmatrix} \qquad \cdots (3)$$

[Formula 4]

$$\begin{bmatrix} V_F \\ I_{FB} \end{bmatrix} = \begin{bmatrix} \cosh\{\lambda(y-x)\} & -Z \cdot \sinh\{\lambda(y-x)\} \\ \dfrac{1}{Z}\sinh\{\lambda(y-x)\} & -\cosh\{\lambda(y-x)\} \end{bmatrix}\begin{bmatrix} V_B \\ I_B \end{bmatrix} \qquad \cdots (4)$$

Where a propagation constant λ and a characteristic impedance Z of the distributed constant circuit are expressed as shown in Formula (5) below:

[Formula 5]

$$\lambda = \sqrt{(R + j\omega L)(G + j\omega C)} \quad , \quad Z = \sqrt{\dfrac{R + j\omega L}{G + j\omega C}} \qquad \cdots (5)$$

From the above Formulas (3) to (5), a basic equation (6) of the distributed constant circuit equation shown below can be obtained:

[Formula 6]

$$\cosh(\lambda x)\cdot V_A - Z\cdot\sinh(\lambda x)\cdot I_A$$
$$= \{\cosh(\lambda y)\cosh(\lambda x) - \sinh(\lambda y)\sinh(\lambda x)\}\cdot V_B - Z\cdot\{\sinh(\lambda y)\cosh(\lambda x) - \cosh(\lambda y)\sinh(\lambda x)\}\cdot I_B$$

$$\cdots (6)$$

The calculation to directly determine a solution of Basic Formula (6) of the distributed constant circuit equation is tremendously difficult and is not practical. Thus, in the present embodiment, Basic Formula (6) is approximated up to the square term (secondary approximation) by using approximations of the hyperbolic functions shown in Formulas (7) and (8) below. In this case, Formula (10) is obtained from Formula (6) based on Formula (9):

[Formula 7]

$$\sinh(\lambda x) = \lambda x + \frac{1}{3!}(\lambda x)^3 + \frac{1}{5!}(\lambda x)^5 + \Lambda\ \Lambda \qquad \cdots (7)$$

[Formula 8]

$$\cosh(\lambda x) = 1 + \frac{1}{2!}(\lambda x)^2 + \frac{1}{4!}(\lambda x)^4 + \Lambda \ \Lambda \qquad \cdots (8)$$

[Formula 9]

$$\sinh(\lambda x) \cong \lambda x \qquad \cosh(\lambda x) \cong 1 + \frac{1}{2}(\lambda x)^2 \qquad \tanh(\lambda x) \cong \lambda x \qquad \cdots (9)$$

[Formula 10]

$$V_A + \lambda x \cdot \frac{\lambda x}{2} \cdot V_A - \lambda x \cdot Z \cdot I_A =$$

$$V_B + \frac{\lambda^2(x^2 + y^2)}{2}V_B + \frac{\lambda^4 x^2 y^2}{4}V_B - \lambda x \cdot \lambda y \cdot V_B - Z \cdot \lambda y \cdot I_B + Z \cdot \frac{\lambda^3 x^2 y}{2} \cdot I_B + Z \cdot \lambda x \cdot I_B + Z \frac{\lambda^3 xy^2}{2} \cdot I_B$$

$$\cdots (10)$$

Further, if terms of $\lambda^3$ or higher in Formula (10) are approximated (tertiary approximation) to 0, Formula (11) below is obtained. From Formula (11), the location distance x as a solution can be determined:

[Formula 11]

$$x = \frac{V_A - V_B + y \lambda Z\left\{I_B - \frac{\lambda}{2Z}(y-x)V_B\right\}}{\lambda Z \cdot \left[\left\{I_A - \frac{\lambda}{2Z}xV_A\right\} + \left\{I_B - \frac{\lambda}{2Z}(y-x)V_B\right\}\right]} = \frac{V_A - V_B + l \cdot z\left\{I_B - \frac{Y}{2}(l-x)V_B\right\}}{z\left[\left\{I_A - \frac{Y}{2}xV_A\right\} + \left\{I_B - \frac{Y}{2}(l-x)V_B\right\}\right]}$$

$$\cdots (11)$$

The location distance x can also be determined from Formula (12) below, which is determined by transforming the above Formula (10) differently:

[Formula 12]

$$x = \frac{V_A - V_B + y \cdot \lambda Z \cdot I_B}{\lambda Z \cdot \left\{I_A + I_B - \frac{\lambda}{2Z}(K_A \cdot V_A + K_B \cdot V_B)\right\}} = \frac{V_A - V_B + l \cdot z \cdot I_B}{z \cdot \left\{I_A + I_B - \frac{l \cdot Y}{2}(K_A \cdot V_A + K_B \cdot V_B)\right\}}$$

$$\text{wherein,} \quad K_A = x, \quad K_B = 2y - x - \frac{y2}{x} \qquad \cdots (12)$$

Form the above Formula (11) or (12), an initial solution x of the location distance by using a predetermined initial value such as 0 or y/2 and sets the initial solution x as an initial location result. Then, the initial location result is used to carry out a recursive calculation that calculates the location distance x again and a final location result is determined by doing a convergence test by a few recursive calculations. The final location result determined by the location operation unit 22 is sent to the location result output unit 23. Lastly, the location result output unit 23 outputs the final location result operated by the location operation unit 22 (step 205 of the flow chart in FIG. 3).

(Operation effect)

In the first embodiment, as described above, the location distance x is determined by using an approximation of the distributed constant circuit equation such as Formula (11) or Formula (12). Accordingly, the influence of a charging current due to the electrostatic capacitance can be avoided. Therefore, the location error can significantly be reduced even for the transmission line 1 having a large electrostatic capacitance or charging current such as a long-distance transmission line and a cable transmission line and the location distance x can be determined with high precision.

Also in the present embodiment, an approximation is used for the calculation of the location distance x and thus, compared with a case when a solution of Basic Formula (6) of the distributed constant circuit equation is directly determined, the calculation is easier and practical. Moreover, if a recursive convergence calculation is carried out in the form in which the solution x is substituted into the right side like in the above Formula (12), it becomes unnecessary to calculate a cubic root, lowering the degree of difficulty of the calculation to a level at which the calculation can be carried out only by four fundamental operations of arithmetic.

Further, the operation load can be adjusted to an appropriate level by adjusting the number of times of convergence calculation. For example, by limiting the number of times of convergence calculation by setting the upper limit of the number of times of convergence calculation, the operation load can be adjusted within a practical range. Therefore, even a so-called embedded processor can calculate the location distance x easily with high precision without relying on a high-performance CPU and is very practical.

Therefore, according to a fault point location method and system in the first embodiment, even if a system fault occurs in a transmission line with a large electrostatic capacitance and charging current, the influence of the electrostatic capacitance and charging current can be excluded by determining the location distance to a fault point by an approximation of the distributed constant circuit equation. As a result, a high-precision fault point location can be realized by at a level of calculation superior in practicality.

The graph in FIG. 4 compares the first embodiment and a conventional method and is an EMTP simulation result of FL location in a parallel two-line very long-distance transmission line of 400 km at 275 kV. A curve 41 shown as a broken line and a curve 42 shown as a solid line in FIG. 4 are both simulation results in the first embodiment when a recursive convergence calculation is carried out by using the above Formula (12) and reference numeral 41 denotes a simulation result of a single line and reference numeral 42 denotes a simulation result of a parallel line. A curve 43 is a simulation result of the conventional method when the location distance x is calculated by using the above Formula (2). The Formula (2) is an approximation up to the first power term (primary approximation) of Basic Formula (6) of the distributed constant circuit equation by using approximations shown in the above Formulas (7) and (8). As shown in the graph, while the location error according to the conventional method is about $\pm 7\%$, the location error according to the first embodiment is less than $\pm 0.5\%$ for both the single line and the parallel line.

(2) Second embodiment

(Configuration)

Subsequently, the second embodiment will be described. The configuration of a fault point location system according to the second embodiment is the same as in the first embodiment in FIG. 1. Thus, elements common to each embodiment will be described by using the same reference numerals.

(Location method)

The second embodiment is different from the first embodiment in a portion of the processing function of the location processing apparatus 20 and thus, the different processing function of the location processing apparatus 20 will mainly be described. The location processing apparatus 20 in the second embodiment also sets the line length y and the transmission line constant Z (vector quantity) per unit length, but is **characterized in that** a mode conversion amount is used when the location distance x is determined.

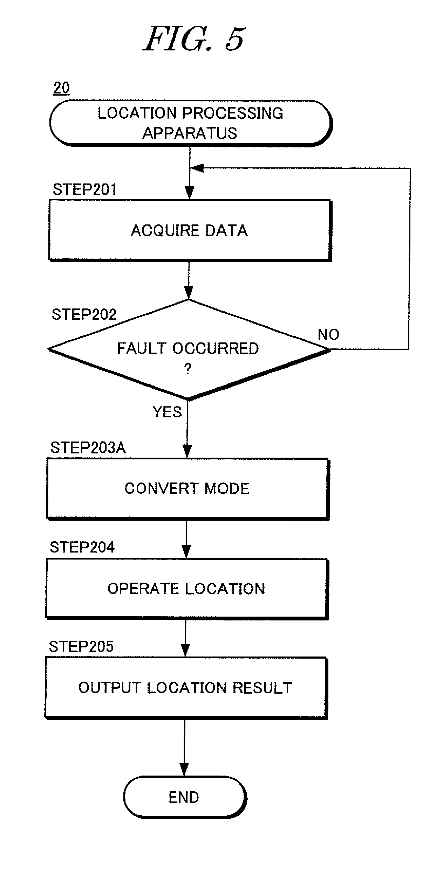

FIG. 5 is a flow chart showing the processing function of the location processing apparatus 20 according to the second embodiment. In FIG. 5, in step 201, data transmitted from the input processing apparatuses 10A, 10B is acquired. Step 201 is a processing step corresponding to the data acquisition unit 21 in FIG. 1.

After data being acquired in step 201, if, in step 202, it is determined that a fault has occurred (Yes in step 202), in next step 203A, a mode conversion is made. If, in step 202, it is determined that no fault has occurred (No in step 202), the processing returns to step 201. Next, in step 204, a location operation is performed by using setting values of respective phase voltage and respective phase current data, the line constant Z and the like.

Steps 202, 203, and 204 are processing steps corresponding to the location operation unit 22 in FIG. 1. Then, in next step 205, a location result is output. Step 205 is a step corresponding to the location result output unit 23 in FIG. 1.

The three-phase direct method is described in the first embodiment described above and in that case, the location distance x to the fault point 2 (F) can easily be determined by applying the above Formulas (4) and (9) to fault phases a, b, c, ab, bc, ca, abc. However, if the Formulas (4) and (9) are applied to the phase b when the fault phase is the phase a, an error has a great influence, making operations difficult. Thus, as described in the flow chart in FIG. 3, the fault phase selection processing (step 203) is needed in the first embodiment.

In the second embodiment, by contrast, a mode conversion of a positive phase quantity of the method of symmetrical coordinates or the like is made (step 203A) and thus, the fault phase selection processing is not needed. When the mode conversion of the positive phase quantity of the method of symmetrical coordinates is used, a mode conversion matrix of the positive phase quantity of the method of symmetrical coordinates shown in Formula (13) below is applied. When a conversion matrix of an amount $\alpha$ of a Clark conversion is used, Formula (14) below is used.

In terms of properties of mode conversion, approximations of the distributed constant circuit equation can be applied to one-phase, two-phase, and three-phase faults without making a fault point selection for a positive phase quantity, to one-phase and two-phase faults for an opposite phase quantity, and to one-phase faults for a zero phase quantity. In the second embodiment described above, the fault phase selection processing can be omitted and therefore, the operation load can further be reduced.

[Formula 13]

$$A = \frac{1}{3}\begin{bmatrix} 1 & a & a^2 \end{bmatrix} \qquad \cdots (1 3)$$

wherein, $a = -\frac{1}{2} + j\frac{\sqrt{3}}{2}$ , $a^2 = -\frac{1}{2} - j\frac{\sqrt{3}}{2}$

[Formula 14]

$$C = \frac{1}{3}\begin{bmatrix} 2 & -1 & -1 \end{bmatrix} \qquad \cdots (1 4)$$

(Operation effect)

According to the second embodiment described above, in addition to the operation effect of the first embodiment, there is no need to make the fault phase selection of the phases a, b, c, ab, bc, ca, and abc. Therefore, a fault point can be located with high precision while the load of operation processing is reduced.

(Modification of the second embodiment)

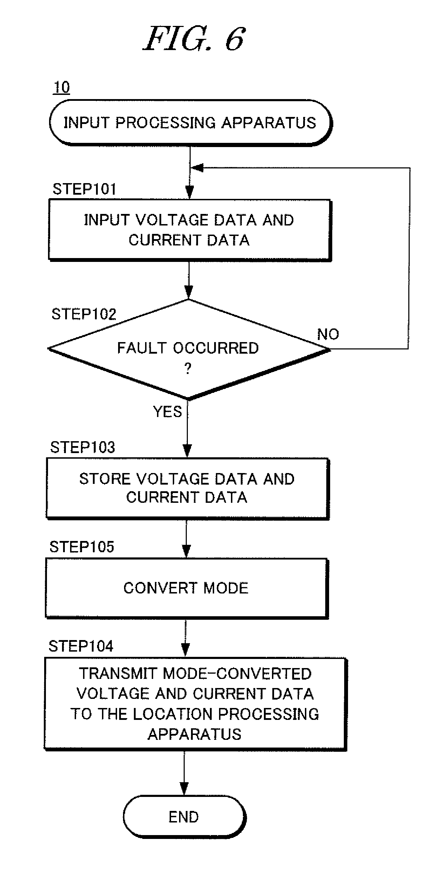

In the second embodiment described above, the mode conversion of the voltage and current was made by the location processing apparatus 20. As a modification, as shown by the flow chart in FIG. 6, the mode conversion is made by the input processing apparatus 10. That is, the input processing apparatus 10 performs mode conversion processing step 105 that converts the mode of the voltage and current after processing step 103 to store voltage and current data.

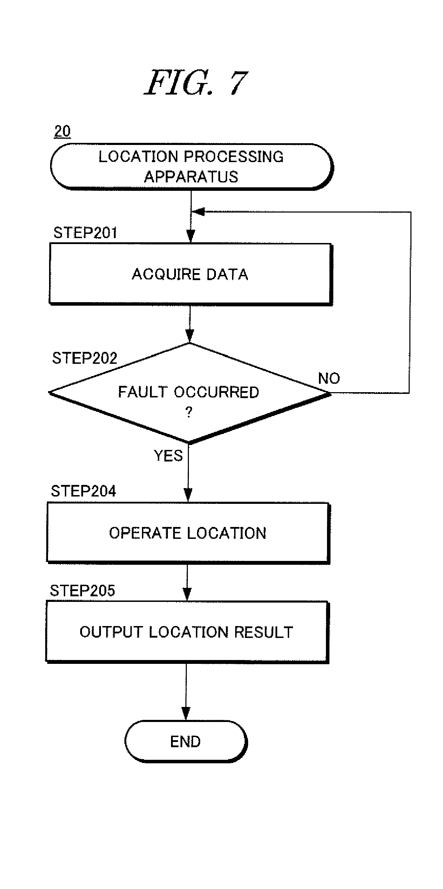

In this case, the mode conversion of the voltage and current by the location processing apparatus 20 is not needed. Thus, as shown in the flow chart in FIG. 7, the mode conversion processing step 203A by the location processing apparatus 20 can be deleted. Accordingly, the operation processing by the location processing apparatus 20 can advantageously be reduced.

(3) Another embodiment

As a modification of the above embodiments, the location processing apparatus 20 directly determines the location distance x by a numeric calculation from the distributed constant circuit equation.

That is, Formula (15) below can be derived by dividing both sides of Basic Formula (6) of the distributed constant circuit equation by a distributed constant circuit of the voltage and current at both ends by a hyperbolic function cosh ($\lambda$x). The location distance x to a fault point in this case can be expressed by Formula (16) below. The location distance x to a fault point can be determined by carrying out a numeric calculation using the voltage and current and the line constant based on Formula (16).

[Formula 15]

$$V_A - Z \cdot \tanh(\lambda x) \cdot I_A$$

$$= \{\cosh(\lambda y) - \sinh(\lambda y) \tanh(\lambda x)\} \cdot V_B - Z \cdot \{\sinh(\lambda y) - \cosh(\lambda y) \tanh(\lambda x)\} \cdot I_B$$

$$\tanh(\lambda x) = \frac{V_A - V_B \cosh(\lambda y) + Z \cdot I_B \sinh(\lambda y)}{Z\{I_A + I_B \cos(\lambda y)\} - V_B \sinh(\lambda y)} \qquad \cdots (15)$$

[Formula 16]

$$x = \frac{1}{\lambda} \tanh^{-1}\left(\frac{V_A - V_B \cosh(\lambda y) + Z \cdot I_B \sinh(\lambda y)}{Z\{I_A + I_B \cos(\lambda y)\} - V_B \sinh(\lambda y)}\right) \qquad \cdots (16)$$

In the embodiment described above, the location distance x is determined directly by a numeric calculation, instead of an approximation calculation, and regarding the effect of being able to avoid the influence of the electrostatic capacitance and charging current, the location error can in principle be reduced to zero. Moreover, compared with a case when a solution is directly determined from Basic Formula (6) of the distributed constant circuit equation, the calculation is simplified to a practical level. Therefore, the location distance x can be determined at a level of practical calculation with extremely high precision.

Several embodiments of the present invention have been described, but these embodiments are presented as exemplary embodiments and do not intend to limit the scope of the invention. These new embodiments can be carried out in various other forms and various omissions, substitutions, and alterations can be made without deviating from the gist of the invention. These embodiments and modifications thereof are included in the scope and gist of the invention and also included in the invention described in the claims and equivalents thereof.

**Claims**

1. A fault location method of locating a fault point by using a voltage and a current of each terminal of a transmission line to be located and a transmission line constant,
   the method comprising:

   determining a formula simplified by a secondary approximation using an approximation of a hyperbolic function from a basic equation of a distributed constant circuit equation using the hyperbolic function or a formula simplified by a division of both sides by the hyperbolic function; and
   calculating a location distance from a predetermined end of the transmission line to the fault point by using the simplified formula.

2. The fault location method according to claim 1, further comprising:

   determining the approximation of the distributed constant circuit equation simplified by the secondary approximation using the approximation of the hyperbolic function from the basic equation of the distributed constant circuit equation using the hyperbolic function;

determining the location distance from the predetermined end of the transmission line to the fault point by using the approximation of the distributed constant circuit equation; and
calculating a final location result by carrying out a recursive convergence calculation of the approximation of the distributed constant circuit equation to an initial location result, with the location distance being set as the initial location result.

3. The fault location method according to claim 2, wherein mode-converted values of the voltage and the current of the each terminal of the transmission line are used.

4. The fault location method according to claim 1, further comprising:

determining a simplified formula of the distributed constant circuit equation simplified by the division of the both sides by the hyperbolic function from the basic equation of the distributed constant circuit equation using the hyperbolic function; and
calculating the location distance from the predetermined end of the transmission line to the fault point by a direct numeric calculation by using simplified formula of the distributed constant circuit equation.

5. A fault location system that locates a fault point by using a voltage and a current of each terminal of a transmission line to be located and a transmission line constant, wherein
an input processing apparatus is installed at each of the terminals and a location processing apparatus is connected to the input processing apparatus via a transmission medium,
the input processing apparatus includes:

a data input unit that receives input of a voltage and a current from each terminal and makes a digital conversion;
a data storage unit that stores voltage data and current data when a fault occurs in a memory based on setting values including a data storage time; and
a data transmission unit that transmits the stored data, and
the location processing apparatus includes:

a data acquisition unit that acquires the data transmitted from the input processing unit;
a location operation unit that uses the setting values including the transmission line constant and the current data and the voltage data acquired by the data acquisition unit, determines a formula simplified by a secondary approximation using an approximation of a hyperbolic function from a basic equation of a distributed constant circuit equation using the hyperbolic function or the formula simplified by a division of both sides by the hyperbolic function, and calculates a location distance from a predetermined end of the transmission line to the fault point by using the simplified formula; and
a location result output unit that outputs a location result of the location operation unit.

## *FIG. 1*

Terminal A　　　　　2 (Point F)　　1　　　　Terminal B

CT10A　　　　　$Z_F$　　CT10B

VT10A　　　　　　　　　　　　VT10B

**Input processing apparatus 10A**

| | |
|---|---|
| Data input unit | 11A |

set value →

| | |
|---|---|
| Data storage unit | 12A |
| Data transmission unit | 13A |

Input processing apparatus

**Input processing apparatus 10B**

| | |
|---|---|
| Data input unit | 11B |

set value →

| | |
|---|---|
| Data storage unit | 12B |
| Data transmission unit | 13B |

Input processing apparatus

NET

Transmission medium

**Location processing apparatus 20**

| | |
|---|---|
| Data acquisition unit | 21 |

set value →

| | |
|---|---|
| Location operation unit | 22 |
| Location result output unit | 23 |

Location processing apparatus

↓

Location result

# *FIG. 2*

<u>10</u>

```
INPUT PROCESSING APPARATUS
```

STEP101

```
INPUT VOLTAGE DATA AND
CURRENT DATA
```

STEP102

```
FAULT OCCURRED
?
```
NO

YES

STEP103

```
STORE VOLTAGE DATA AND
CURRENT DATA
```

STEP104

```
TRANSMIT VOLTAGE DATA AND
CURRENT DATA TO THE LOCATION
PROCESSING APPARATUS
```

```
END
```

# FIG. 3

<u>20</u>

```
┌─────────────────────────────┐
│    LOCATION PROCESSING       │
│        APPARATUS             │
└─────────────────────────────┘
```

STEP201

```
┌─────────────────────────────┐
│        ACQUIRE DATA          │
└─────────────────────────────┘
```

STEP202

```
        FAULT OCCURRED              NO
             ?
```

YES

STEP203

```
┌─────────────────────────────┐
│    DISTINGUISH AND SELECT    │
│       A FAULT PHASE          │
└─────────────────────────────┘
```

STEP204

```
┌─────────────────────────────┐
│      OPERATE LOCATION        │
└─────────────────────────────┘
```

STEP205

```
┌─────────────────────────────┐
│    OUTPUT LOCATION RESULT     │
└─────────────────────────────┘
```

```
┌───────┐
│  END  │
└───────┘
```

# FIG. 4

COMPARISON WITH CONVENTIONAL METHOD

(EMTP SIMULATION RESULT OF FL LOCATION IN PARALLEL 2-LINE VERY LONG-DISTANCE
TRANSMISSION LINE OF 400 km AT 275 kV)

# FIG. 5

20

LOCATION PROCESSING
APPARATUS

STEP201

ACQUIRE DATA

STEP202

FAULT OCCURRED
?

NO

YES

STEP203A

CONVERT MODE

STEP204

OPERATE LOCATION

STEP205

OUTPUT LOCATION RESULT

END

# *FIG. 6*

10

INPUT PROCESSING APPARATUS

STEP101

INPUT VOLTAGE DATA AND
CURRENT DATA

STEP102

FAULT OCCURRED
?

NO

YES

STEP103

STORE VOLTAGE DATA AND
CURRENT DATA

STEP105

CONVERT MODE

STEP104

TRANSMIT MODE-CONVERTED
VOLTAGE AND CURRENT DATA
TO THE LOCATION PROCESSING
APPARATUS

END

# FIG. 7

20
**LOCATION PROCESSING APPARATUS**

STEP201

**ACQUIRE DATA**

STEP202

**FAULT OCCURRED ?** — NO

YES

STEP204

**OPERATE LOCATION**

STEP205

**OUTPUT LOCATION RESULT**

**END**

*FIG. 8A*

*FIG. 8B*

## INTERNATIONAL SEARCH REPORT

| | International application No. |
|---|---|
| | PCT/JP2010/004852 |

### A. CLASSIFICATION OF SUBJECT MATTER
*G01R31/08*(2006.01)i

According to International Patent Classification (IPC) or to both national classification and IPC

### B. FIELDS SEARCHED

Minimum documentation searched (classification system followed by classification symbols)
G01R31/08

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 1-207675 A  (Nippon Telegraph And Telephone Corp.), 21 August 1989 (21.08.1989), entire text; all drawings (Family: none) | 1-5 |
| A | JP 59-135377 A  (Fuji Denki Seizo Kabushiki Kaisha), 03 August 1984 (03.08.1984), entire text; all drawings (Family: none) | 1-5 |

☐ Further documents are listed in the continuation of Box C.　　☐ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| 22 October, 2010 (22.10.10) | 02 November, 2010 (02.11.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2818248 B

- JP 3356484 B

**Non-patent literature cited in the description**

- **Hoki ; Kitani.** Fault Point Spotting Device of Transmission Line. Ohmsha, Ltd, 1957, 45